# EUROPÄISCHE PATENTANMELDUNG

(11) **EP 1 380 896 A1**
(43) Veröffentlichungstag der Anmeldung: **14.01.2004**
(21) Anmeldenummer: 02015716.0
(22) Anmeldetag: 12.07.2002
(51) Int. Cl.: G03F 7/20, G02B 1/02, G02B 1/08, G02B 27/00

(54) **Optisches System mit kompensierter Spatial Dispersion**

(71) Anmelder: Schott Glas, 55122 Mainz (DE); CARL-ZEISS-STIFTUNG trading as SCHOTT GLAS, 55122 Mainz (DE)
(72) Erfinder: Nattermann, Kurt, Dr., 55437 Ockenheim (DE); Mörsen, Ewald, Dr., 55130 Mainz (DE)
(74) Vertreter: Fuchs Mehler Weiss & Fritzsche, Patentanwälte

(57) **Zusammenfassung**

Bei einem optischen System mit kompensierter Spatial Dispersion, mit einer optischen Achse (10), mit einem ersten optischen Element (11, 17, 19, 26) aus einem Material mit kubischer Kristallstruktur, das eine erste Orientierung in bezug auf die optische Achse (10) aufweist, und mit einem zweiten optischen Element (12, 18, 20, 27) aus dem Material, das eine der ersten Orientierung entsprechende zweite Orientierung in bezug auf die optische Achse (10) aufweist, wobei die zweite Orientierung gegen die erste Orientierung um einen Winkel um die optische Achse (10) gedreht ist, tritt immer noch eine unerwünscht große Retardierung durch Spatial Dispersion auf. Es wird deshalb vorgeschlagen, daß mindestens das erste optische Element (11, 17, 19, 26) oder das zweite optische Element (12, 18, 20, 27) mit einer Druckspannung (σ, σ1, σ2) radial in bezug auf die optische Achse (10) zum Kompensieren der Spatial Dispersion vorgespannt ist.

## Beschreibung

Die Erfindung betrifft ein optisches System mit kompensierter Spatial Dispersion, mit einer optischen Achse, mit einem ersten optischen Element, das eine erste Orientierung in bezug auf die optische Achse aufweist, und mit einem zweiten optischen Element, das eine zweite Orientierung in bezug auf die optische Achse aufweist, wobei die zweite Orientierung gegen die erste Orientierung um einen Winkel um die optische Achse gedreht ist.

Materialien für optische Systeme wie z. B. Objektive, Linsen, Prismen sowie Anordnungen aus mehreren solcher Teile bzw. Elementen sollten im wesentlichen optisch isotrop sein, d. h. ein sie durchdringender Lichtstrahl sollte sich in alle Richtungen und unabhängig von seiner Polarisation gleich schnell fortbewegen. Ein typisches Anzeichen für verschieden schnelle Ausbreitung in einem Material ist z. B. die Doppelbrechung an manchen Kristallen. Bei kubischen Kristallen tritt üblicherweise Doppelbrechung im herkömmlichen Sinne zwar nicht auf. Jedoch sind diese für Licht kurzer Wellenlängen optisch anisotrop. Dieser Effekt wird als Spatial Dispersion bezeichnet und ist eine intrinsische Eigenschaft des jeweiligen Kristalles. Aufgrund dieser Spatial Dispersion kommt es bei der Verwendung von Material mit kubischer Kristallstruktur in optischen Systemen zu einer sogenannten Retardierung, d.h. ein Auseinanderlaufen der Wellenfronten; was zu unerwünschten Interferenzeffekten führt. Beispielsweise Objektive für die Mikrolithographie sind beugungsbegrenzt, wodurch unerwünschte Interferenzeffekte zu einer Verschlechterung der Abbildungsleistungen führen. Bei der Mikrolithographie wird Licht kurzer Wellenlänge, beispielsweise Licht einer Wellenlänge von λ = 157 nm verwendet. Diese kurzwellige, im UV-Bereich angesiedelte Strahlung stellt hohe Anforderungen an das Material des optischen Systems. Ein nicht geeignetes Material kann von dieser kurzwelligen Strahlung zerstört werden. Aus diesem Grund wird als Material für die optischen Systeme für die Mikrolithographie bevorzugt CaF₂ verwendet, das auch bei diesen verhältnismäßig kurzen Wellenlängen, also bei energiereicher Strahlung, eine hinreichende Transmission liefert. Nach J.H. Burnett, Z.H. Levine, E. Shirley: "Intrinsic birefringence in calcium fluoride and barium fluoride" Phys. Rev. B64, 241102(R), 2001, beträgt die durch die Spatial Dispersion hervorgerufene Retardierung für eine Wellenlänge von λ = 157 nm für [110]-Strahlen in einem CaF₂-Kristall etwa 11,5 nm/cm. Objektive für die Mikrolithographie benötigen wegen ihrer Beugungsbegrenzung jedoch eine Retardierung <1nm/cm. Aus diesem Grunde ist ein optisches System wünschenswert, dessen Spatial Dispersion auf eine Retardierung <1nm/cm begrenzt werden kann, damit beispielsweise CaF₂ als Material für das optische System für die 157nm-Strahlung zur Mikrolithographie verwendet werden kann.

Die sich durch die Spatial Dispersion ergebenden Gangunterschiede der einzelnen Lichtstrahlen sind für verschiedene Lichtausbreitungsrichtungen im Kristall verschieden. Eine Möglichkeit zur Kompensation der Spatial Dispersion ergibt sich zum Beispiel, wenn ein Lichtstrahl entlang seiner Ausbreitungsrichtung in dem ersten optischen Element entlang einer sogenannten schnellen Achse, das heißt einer Achse mit hoher Ausbreitungsgeschwindigkeit, und in dem zweiten optischen Element entlang einer sogenannten langsamen Achse, das heißt einer Achse mit einer geringen Ausbreitungsgeschwindigkeit, läuft. Auf diese Weise läßt sich die durch Spatial Dispersion bewirkte Retardierung zwar kompensieren, jedoch ist die Kompensation noch verhältnismäßig ungenügend. Die verbleibende Retardierung durch Spatial Dispersion führt immer noch zu einer unerwünscht großen Verschlechterung der Abbildungseigenschaften der verwendeten optischen Systeme.

Die Erfindung hat daher zum Ziel, ein optisches System mit Elementen aus Material kubischer Kristallstruktur anzugeben, dessen Spatial Dispersion effizient kompensiert wird, so daß sich aus dieser Spatial Dispersion nur eine geringe optische Retardierung ergibt.

Dieses Ziel wird durch die in den Ansprüchen definierten Merkmale erreicht. Danach ist bei einem System der eingangs genannten Art mindestens das erste optische Element und/- oder das zweite optische Element mit einer Druckspannung radial in bezug auf die optische Achse zum Kompensieren der Spatial Dispersion vorgespannt. Die Druckspannung wird dabei durch Kräfte erzeugt, die ringsum auf das optische Element gleichmäßig senkrecht auf die optische Achse gerichtet sind.

Durch diese Druckspannung läßt sich eine Spannungsdoppelbrechung hervorrufen, die der Spatial Dispersion überlagert ist. Auf diese Weise läßt sich die Lage der schnellen Achsen und der langsamen Achsen sowie der entlang dieser Achsen auftretende Unterschied der Ausbreitungsgeschwindigkeit verändern und somit die durch ein optisches Element hervorgerufene Retardierung derart einstellen, daß sie sich mit der von dem anderen optischen Element hervorgerufenen Retardierung nahezu vollständig aufhebt. Die Größe der erforderlichen Druckspannung läßt sich entweder experimentell bestimmen, oder es können Rechnungen durchgeführt werden. Hierzu läßt sich beispielsweise das sogenannte Raytracing durchführen. Dazu kann beispielsweise ein herkömmliches Raytracingprogramm, nämlich Code V der Optical Research Associates, 3280 East Foothill Blvd., Passadena, California 91197, USA, verwendet werden, wobei einige spannungsoptische Korrekturen erforderlich sind.

Bei einer bevorzugten Ausführungsform der Erfindung ist die Druckspannung im Wesentlichen homogen und isotrop. Dazu werden die durch die Druckspannung auf das optische Element ausgeübten Kräfte gleichmäßig, beispielsweise am Außenumfang einer Linse radialsymmetrisch einwärts gerichtet. Die Druckspannung sollte 0,5 bis 50 MPa vorzugsweise 0,6 bis 1,6 MPa betragen.

Zur leichteren Beherrschbarkeit und zur besseren Berechenbarkeit des Systems sollte das erste optische Element und/oder das zweite optische Element in einen gleichmäßigen ebenen Spannungszustand in einer Ebene rechtwinklig, d.h. senkrecht und zwar üblicherweise radial zur optischen Achse vorgespannt sein. Dieser ebene Spannungszustand läßt sich durch Anlegen einer gleichmäßigen Druckspannung vom Außenumfang her einfach und reproduzierbar herstellen.

Die Druckspannung wird üblicherweise durch eine Spannvorrichtung ausgeübt. Als Spannvorrichtung sind sämtliche Vorrichtungen geeignet, welche Druckkräfte gleichmäßig auf das optische Element, insbesondere radial in Richtung auf die optische Achse ausüben. Übliche Vorrichtungen sind z. B. ein Spannring, ein hydrostatischer, das Element einfassender Ring, wie z. B. ein Schlauch, oder ein anderes übliches Mittel wie es z. B. zum isostatischen Pressen verwendet wird.

Besonders einfach läßt sich eine radiale Druckspannung durch einen Spannring erzeugen. Mit diesem Spannring kann beispielsweise die Außenumfangsfläche einer Linse nach innen hin vorgespannt werden, so dass die Spann- bzw. Druckkräfte in Richtung der optischen Achse wirken. Es ist auch von Vorteil, wenn Stellmittel zum Einstellen der Druckspannung vorhanden sind. Mittels dieser Stellmittel kann der gewünschte Wert eingestellt werden. Insbesondere beim experimentellen Bestimmen der erforderlichen Druckspannung läßt sich so die Druckspannung auf einen minimalen Wert der verbleibenden Retardierung einstellen.

Bei einer anderen Weiterbildung der Erfindung ist das erste optische Element mit einer ersten Druckspannung und das zweite optische Element mit einer von dieser verschiedenen zweiten Druckspannung vorgespannt. Durch dieses Vorspannen mit unterschiedlicher Druckspannung können so die Retardierungen der beiden optischen Elemente besonders wirkungsvoll miteinander kompensiert werden.

Vorzugsweise weist das Material eine kubische Kristallstruktur auf wie z. B. CaF₂ oder BaF₂. Diese Kristalle haben insbesondere für kurzwellige Strahlungen besonders wünschenswerte Eigenschaften. Eine gute Transmission für kurzwellige Strahlung hat beispielsweise auch MgF₂.

In der erfindungsgemäßen Anordnung weisen das erste und das zweite optische Element eine erste und zweite Orientierung mit ersten und zweiten Achsen auf, die sowohl gleich als auch verschieden sein können, und die parallel zueinander oder auch in einem Winkel zueinander verlaufen können. Dabei ist es weiter von Vorteil, wenn sogenannte schnelle Achsen der ersten Orientierung sogenannten langsamen Achsen der zweiten Orientierung zugeordnet sind bzw. umgekehrt. In diesem Fall wird das schnelle Ausbreiten der Wellenfronten in dem ersten optischen Element entlang der schnellen Achse durch ein langsames Ausbreiten in dem zweiten optischen Element entlang der zugeordneten langsamen Achsen kompensiert und/oder umgekehrt.

In einer erfindungsgemäß bevorzugten Ausführungsform sind die optischen Elemente entsprechend ihrer Rotationssymmetrie bezüglich ihrer optischen Achse gegeneinander um diese gedreht. Dabei beträgt der Drehwinkel vorzugsweise die Hälfte des Symmetriedrehwinkels des Materials, aus welchem die optischen Elemente bestehen bzw. ein ungeradzahliges Vielfaches davon, bei der jeweiligen Orientierung. Bei einem Material mit einer dreifachen Symmetrie beträgt der Symmetriewinkel 120°, d.h. die Elemente sollen um die Hälfte dieses Winkels, also 60° bzw. das 3, 5, 7-fache davon, gegeneinander verdreht sein. Bei einem Material mit einer n-fachen Rotationssymmetrie bezüglich der optischen Achse beträgt der Symmetriewinkel 360°/n; folglich sollen die Elemente um 0,5·360°/n oder ein ungeradzahliges Vielfaches davon gegeneinander verdreht sein.

Eine vorteilhafte Ausgestaltung des optischen Systems mit den Erfindungsmerkmalen ergibt sich, wenn bei einer vierfachen Drehsymmetrie des Materials in der ersten Orientierung um die optische Achse der Winkel 45°, 135°, 225° oder 315° beträgt. Dies ist beispielsweise dann der Fall, wenn bei einem CaF₂-Kristall die [100]-, [010]-, [001]-Achse in der ersten Orientierung und der zweiten Orientierung parallel zur optischen Achse ist. In diesem Fall ist die (100)-, (010)-, (001)-Fläche des CaF₂-Kristalls rechtwinklig zur optischen Achse angeordnet. Eine Drehung um einen Winkel von 90° oder ein Vielfaches davon führt dann jeweils wieder zu einer gleichen Anordnung des Kristalls und somit der schnellen Achsen und der langsamen Achsen.

Bei einem Kristall mit dreifacher Drehsymmetrie des Materials in der ersten Orientierung um die optische Achse sollte der Winkel 60°, 180° oder 300° betragen. Dies ist bei CaF₂ beispielsweise dann der Fall, wenn die [111]-, [-1-11]-, [1-11]-Achse in der ersten Orientierung und der zweiten Orientierung parallel zur optischen Achse ist. In diesem Fall ist die (111)-, (-1-11)-, (1-11)-Fläche des Kristalls rechtwinklig zur optischen Achse angeordnet. Eine Drehung um 120° oder ein Vielfaches davon führt dann zu einer gleichen Anordnung des Kristalls und somit der schnellen Achsen und der langsamen Achsen.

Eine Weiterbildung der Erfindung zeichnet sich dadurch aus, daß das erste optische Element und das zweite optische Element Flächen aufweisen, die plan/plan oder konvex/konkav bzw. konkav/konvex ausgebildet und die einander zugewandt sind. Es ist aber auch eine Ausgestaltung möglich, bei der die Flächen plan/konkav oder plan/konvex sind. Wenn die einander zugeordneten Flächen plan sind, können die beiden optischen Elemente beispielsweise als zwei Hälften einer Konvex-Konvex-Linse ausgebildet sein. Durch eine konvex/konkave Ausbildung bzw. eine konkav/konvexe Ausbildung lassen sich auch aufwendigere Linsengruppen gestalten. Die beiden optischen Elemente können fest miteinander verbunden oder auch durch einen Spalt voneinander getrennt sein.

Vorzugsweise bilden das erste optische Element und das zweite optische Element die Endgruppe eines Objektivs. In diesem Fall kann durch entsprechende Ausgestaltung dieser Endgruppe die Retardierung des gesamten Systems ausgeglichen werden. Von der Endgruppe bis zu dem Punkt, an dem die Abbildung erfolgt, treten dann keine weiteren Abbildungsfehler mehr auf.

Es ist auch möglich, daß das erste optische Element und das zweite optische Element ein planes Korrekturelement bilden. In diesem Fall kann eine konventionelle Optik verwendet werden, der das erste optische Element und das zweite optische Element als Korrekturelement nachgeschaltet sind. Besonders bevorzugt ist diese Ausgestaltung, wenn das erste optische Element und das zweite optische Element plane Schichten bzw. Scheiben gleicher Dicke sind. Es ergibt sich dadurch ein Korrekturplättchen, das sich einfach montieren und einfach in den Spannungszustand versetzen läßt.

Im folgenden werden Ausführungsbeispiele der Erfindung anhand der Zeichnungen näher erläutert. Es zeigen:
- Fig. 1: eine schematische Darstellung eines kubischen Kristalls zur Erläuterung der Kristallachsen und Kristallflächen,
- Fig. 2: einen Meridionalschnitt durch ein optisches System mit den Erfindungsmerkmalen als ein erstes Ausführungsbeispiel,
- Fig. 3: eine schematische Darstellung ähnlich Fig. 1 zum Erläutern der Lage einer (111)-Fläche,
- Fig. 4: eine schematische Darstellung eines optischen Systems mit den Erfindungsmerkmalen als ein zweites Ausführungsbeispiel,
- Fig. 5: eine Darstellung ähnlich Fig. 3 zur Erläuterung der [-1,-1,2]-Achse.
- Fig. 6: eine schematische Darstellung eines optischen Systems mit den Erfindungsmerkmalen als ein drittes Ausführungsbeispiel, und
- Fig. 7: eine schematische Darstellung eines optischen Systems mit einer Linse und einer Korrekturplatte als ein weiteres Ausführungsbeispiel der Erfindung.

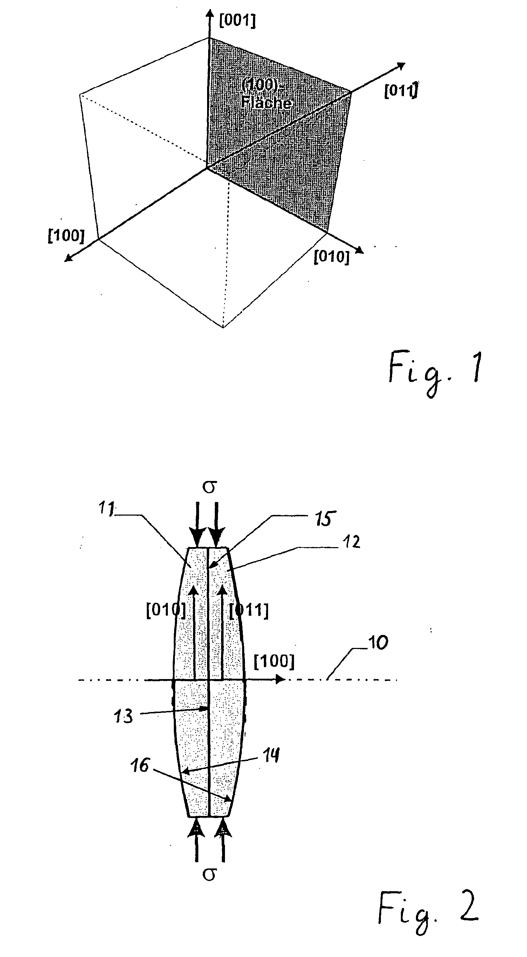

Fig. 1 zeigt eine schematische Darstellung eines Kristalls mit kubischer Kristallstruktur zum Erläutern der Kristallachsen und der Kristallflächen. Es wird nachfolgend zur Definition der Kristallachsen den üblichen Konventionen gefolgt, wie sie beispielsweise in C. Kittel "Einführung in die Festkörperphysik" 4. Auflage, Oldenbourg, München, 1976 wiedergegeben sind. In der Figur dargestellt sind die Richtungen [100], [010] und [001]. Außerdem ist in der Figur die (100)-Fläche dargestellt, auf der der Richtungsvektor [100] als Flächennormale senkrecht steht. Weiter in der Figur dargestellt ist der Richtungsvektor [011], der mit einem Winkel von 45° zu den Richtungen [010] und [001] verläuft.

Fig. 2 zeigt ein optisches System mit einer optischen Achse 10 als ein erstes Ausführungsbeispiel der Erfindung. Das gezeigte optische System weist ein erstes optisches Element 11 und ein zweites optisches Element 12 auf. Das erste optische Element 11 und das zweite optische Element 12 bestehen bei dem gezeigten Ausführungsbeispiel aus CaF₂-Kristallen, deren (100)-Fläche jeweils rechtwinklig zur optischen Achse 10 angeordnet ist, das heißt, deren Achsen [100] sind jeweils parallel zur optischen Achse 10 ausgerichtet. Das erste optische Element 11 weist eine plane Fläche 13 und eine gekrümmte Fläche 14 auf und ist als Konvex-Plan-Linse ausgebildet. Das zweite optische Element weist ebenfalls eine plane Fläche 15 und eine gekrümmte Fläche 16 auf und ist ebenfalls als Konvex-Plan-Linse ausgebildet. Die planen Flächen 13, 15 sind einander zugewandt angeordnet und liegen berührend aneinander, ohne dass ein Zwischenraum verbleibt. Bei dem gezeigten Ausführungs-beispiel können sie gegebenenfalls auch miteinander verklebt sein. Die planen Flächen 13, 15 sind rechtwinklig zur optischen Achse 10 angeordnet. Auf diese Weise bilden das erste optische Element 11 und das zweite optische Element 12 eine Bikonvex-Linse, die in Fig. 2 im Meridionalschnitt dargestellt ist. Der Strahlengang erfolgt in Fig. 2 von links nach rechts oder auch umgekehrt. Der Durchmesser des ersten optischen Elementes 11 und des zweiten optischen Elementes 12 beträgt beispielsweise jeweils 100 mm. Die Dicke des ersten optischen Elementes 11 und des zweiten optischen Elementes 12 beträgt beispielsweise jeweils 15 mm und der Krümmungsradius der gekrümmten Flächen 14, 16 beispielsweise jeweils 500 mm.

Wie der Figur ebenfalls zu entnehmen ist, ist die [010]-Kristallachse des ersten optischen Elementes 11 rechtwinklig zur optischen Achse 10 in der Figur nach oben in der Papierebene angeordnet. Die Kristallorientierung des zweiten optischen Elementes 12 ist demgegenüber um 45° gegen die des ersten optischen Elementes 11 um die optische Achse 10 gedreht. Dies wird dadurch deutlich, daß für das zweite optische Element 12 die [011]-Kristallachse rechtwinklig zur optischen Achse 10 in der Papierebene nach oben dargestellt ist. Das erste optische Element 11 und das zweite optische Element 12 bilden gemeinsam ein optisches System in Form eines rotationssymmetrischen Körpers. Von ihren Außenumfangsflächen her werden das erste optische Element 11 und das zweite optische Element 12 mit einer Druckspannung σ beaufschlagt. Die Druckspannung σ wird mittels eines nicht in der Figur eingezeichneten Spannringes am Linsenumfang erzeugt. Auf diese Weise wird die Druckspannung σ gleichmäßig auf den Außenumfang übertragen. Dadurch wird in dem ersten optischen Element 11 und in dem zweiten optischen Element 12 jeweils ein bezüglich der Spannung radial isotroper und homogener Zustand bewirkt.

Trifft z.B. auf das optische System von Fig. 2 z. B. von links her entlang der optischen Achse 10 ein Strahlenbündel auf die gekrümmte Fläche 14 des ersten optischen Elementes 11 mit einer Wellenlänge von 157 nm, einem Durchmesser von D = 80 mm und einem Öffnungswinkel von 2 θₘₐₓ = 106° auf, so ergibt sich unter Zugrundelegen einer numerischen Apertur von NA = 0,8 durch das erste optische Element 11 und das zweite optische Element 12 bei einer Druckspannung von σ = -1,35 MPa eine maximale Phasendifferenz von 6°. Vergleicht man diesen Wert mit einer resultierenden Phasendifferenz von 50° ohne angelegte Druckspannung (σ = 0), wird durch das Anlegen der Druckspannung eine Reduzierung auf nur ca. 12% des Wertes ohne Druckspannung erreicht.

Ähnliche Werte ergeben sich außerdem dann, wenn die [010]-oder [001]-Achsen des ersten optischen Elementes 11 und des zweiten optischen Elementes 12 parallel zur optischen Achse 10 angeordnet sind und das zweite optische Element 12 gegen das erste optische Element 11 um 45° um die optische Achse 10 gedreht ist. Außerdem sind anstelle des Drehwinkels von 45° auch 135°, 225° oder 315° möglich. Die planen Flächen 13, 15 müssen auch nicht notwendigerweise miteinander verklebt werden, sondern es kann auch ein Spalt bzw. Zwischenraum zwischen diesen verbleiben.

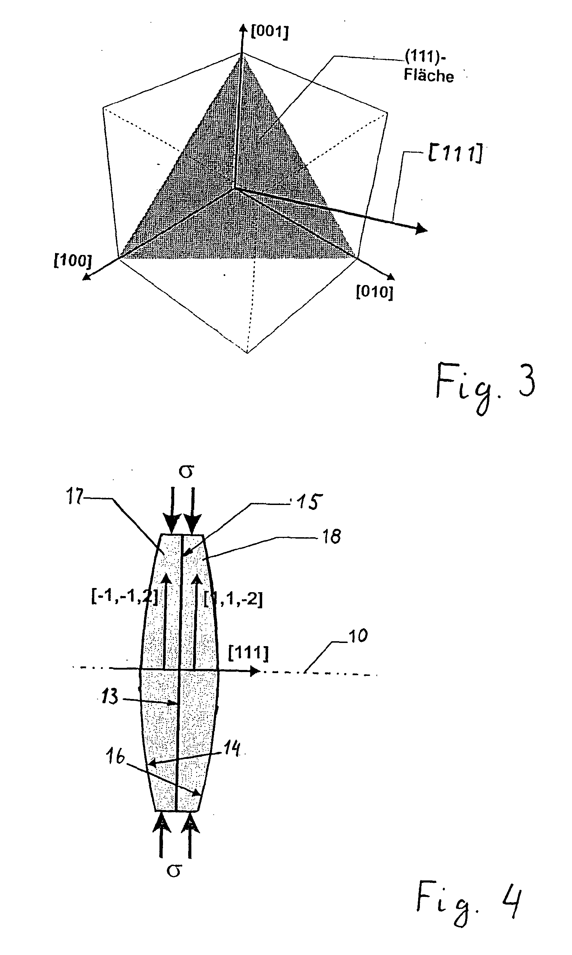

Fig. 3 zeigt schematisch eine Darstellung ähnlich Fig. 1, wobei in Fig. 3 eine (111)-Fläche sowie eine [111]-Richtung dargestellt sind. Die [111]-Richtung verläuft als Raumdiagonale in der von den Richtungen [100], [001] und [010] beschriebenen kubischen Struktur und ist rechtwinklig zu der (111)-Fläche angeordnet.

In Fig. 4 ist ein zweites Ausführungsbeispiel eines optischen Systems mit den Erfindungsmerkmalen dargestellt. Das optische System weist ein erstes optisches Element 17 und ein zweites optisches Element 18 ähnlich dem ersten optischen Element 11 und dem zweiten optischen Element 12 auf. Gleiche Elemente tragen die gleichen Bezugszeichen. Das erste optische Element 17 und das zweite optische Element 18 unterscheiden sich von dem ersten optischen Element 11 und dem zweiten optischen Element 12 durch die Kristallorientierungen.

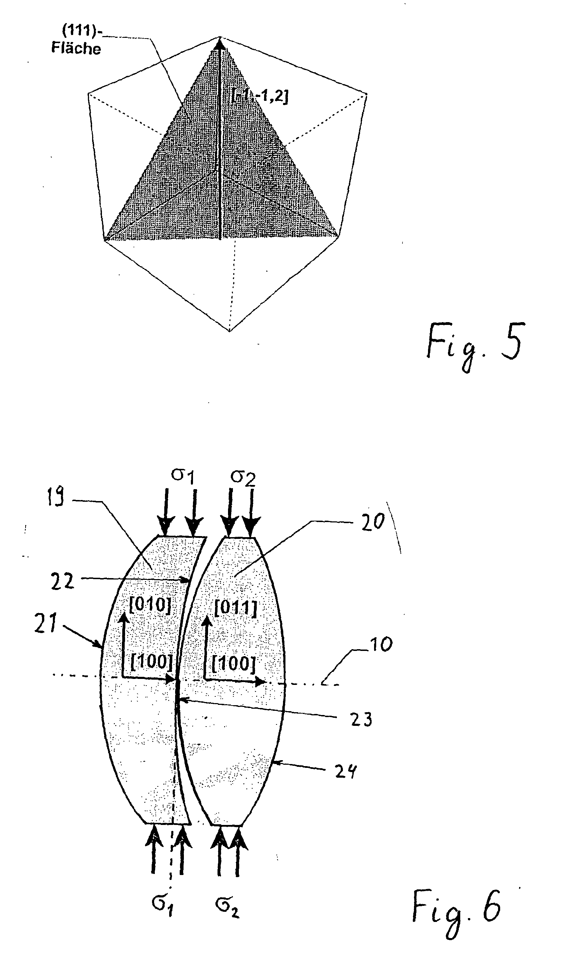

Bei dem ersten optischen Element 17 und dem zweiten optischen Element 18 sind die [111] -Richtungen jeweils parallel zur optischen Achse 10 angeordnet. Bei dem ersten optischen Element 17 ist die [-1,-1,2]-Richtung rechtwinklig zur optischen Achse 10 und in der Figur nach oben in der Papierebene eingezeichnet. Wie sich Fig. 5 entnehmen läßt, ist die [-1,-1,2]-Richtung parallel zur (111)-Fläche angeordnet und weist in der Fig. 5 nach oben. Demgegenüber ist bei dem zweiten optischen Element 18 die Richtung [11-2] rechtwinklig zur optischen Achse 10 und in der Figur in der Papierebene nach oben hin angeordnet. In der Fig. 5 ist die Richtung [1,1,-2] parallel zur Richtung [-1,-1,2], jedoch entgegengesetzt gerichtet, angeordnet. Das zweite optische Element 18 ist somit um 180° gegen das erste optische Element 17 um die optische Achse 10 gedreht.

Unter den gleichen Voraussetzungen eines von links in der Figur auftreffenden Strahlenbündels mit D = 80 mm, 2 θₘₐₓ = 106° und NA = 0,8 ergibt sich bei einer Strahlungslängenwelle von wiederum 157 nm mit einer Druckspannung von σ = -1,7 MPa eine maximale Phasendifferenz von ca. 4,5°.

Diese maximale Phasendifferenz beträgt nur etwa 13% des Wertes der Phasendifferenz ohne Druckspannung σ.

Die gleichen Ergebnisse ergeben sich auch dann, wenn bei dem ersten Element 17 und bei dem zweiten Element 18 anstelle der [111]-Richtung die [-1,1,1]-, [-1,-1,1]- oder [1,-1,1]-Richtungen parallel zur optischen Achse 10 angeordnet und das zweite optische Element 18 gegen das erste optische Element 17 um 180° gedreht ist. Den gleichen Effekt erzielt man auch mit einer Drehung des zweiten optischen Elementes 18 um 60° oder 300° gegen das erste optische Element 17 um die optische Achse 10.

Fig. 6 zeigt ein drittes Ausführungsbeispiel eines optischen Systems mit den Erfindungsmerkmalen in einer schematischen Darstellung. Die Kristallorientierungen des ersten optischen Elementes 19 und des zweiten optischen Elementes 20 entsprechen denen des ersten optischen Elementes 11 und des zweiten optischen Elementes 12 des ersten Ausführungsbeispieles in Fig. 2. Das erste optische Element 19 ist eine Konvex-Konkav-Linse mit einer konvex gekrümmten Fläche 21 und einer konkav gekrümmten Fläche 22. Der Krümmungsradius der konvex gekrümmten Fläche 21 beträgt 750 mm. Der Krümmungsradius der konkav gekrümmten Fläche 22 beträgt 1.000 mm. Die Dicke des ersten optischen Elementes 19 im Bereich der optischen Achse 10 beträgt 15 mm. Das zweite optische Element 20 ist eine Bikonvex-Linse mit einer ersten konvex gekrümmten Fläche 23 und einer zweiten konvex gekrümmten Fläche 24. Der Krümmungsradius der konvex gekrümmten Flächen 23, 24 beträgt jeweils 500 mm. Das zweite optische Element 20 hat eine Dicke von 30 mm. Der Durchmesser des ersten optischen Elementes 19 und des zweiten optischen Elementes 20 beträgt 100 mm. Die erste konvex gekrümmte Fläche 23 ist der konkav gekrümmten Fläche 22 zugeordnet und dieser zugewandt. Auf diese Weise ist die erste konvex gekrümmte Fläche 23 gleichsam in der durch die konkav gekrümmte Fläche 22 gebildeten Mulde angeordnet.

Das erste optische Element 19 wird an seinem Außenumfang gleichmäßig mit einer Druckspannung σ1 beaufschlagt. Das zweite optische Element 20 wird an seinem Außenumfang gleichmäßig mit einer Druckspannung σ2 beaufschlagt. Für ein Strahlenbündel mit D = 80 mm, 2 θₘₐₓ = 106°, NA = 0,8 und eine Wellenlänge von 157 nm auf der konkav gekrümmten Fläche 22 beträgt der maximale Phasenunterschied bei σ1 = -40 MPa und σ2 = -1,0 MPa ca. 7°. Dies entspricht gegenüber einem maximalen Phasenunterschied von ca. 88° ohne angelegte Druckspannungen einer Reduzierung auf weniger als 10%.

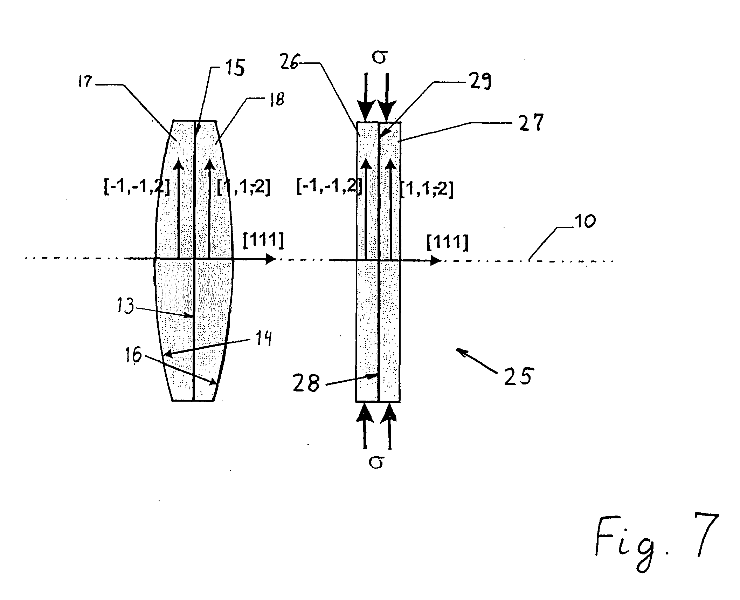

Fig. 7 zeigt ein weiteres Ausführungsbeispiel eines optischen Systems mit den Erfindungsmerkmalen. Das optische System weist hier die Linse mit dem ersten optischen Element 17 und dem zweiten optischen Element 18 von Fig. 4 auf, denen ein Korrekturelement 25 nachgeschaltet ist. Das Korrekturelement 25 hat hier ein erstes optisches Element 26 und ein zweites optisches Element 27, die jeweils als plane Scheiben ausgebildet sind. Das erste optische Element 26 und das zweite optische Element 27 bestehen jeweils aus einem CaF₂-Kristall, wobei die [111]-Achsen des ersten optischen Elementes 26 und des zweiten optischen Elementes 27 parallel zur optischen Achse 10 angeordnet sind. Das erste optische Element 26 hat eine plane Fläche 28 und das zweite optische Element 27 hat eine plane Fläche 29, die der planen Fläche 28 zugewandt ist. Die Richtung [-1,-1,2] des ersten optischen Elementes 26 ist rechtwinklig zur Richtung [111] in der Figur in der Papierebene nach oben angeordnet. Demgegenüber ist die Orientierung des zweiten optischen Elementes 27 um 180° um die [111]-Richtung gedreht, wodurch die [1,1,-2]-Richtung rechtwinklig zur [111]-Richtung in der Figur in der Papierebene aufwärts angeordnet ist.

Wird ein Strahlenbündel durch das optische System von Fig. 7 geleitet, das an der gekrümmten Fläche 14 einen Durchmesser D = 80 mm, einen Winkelbereich 2 θₘₐₓ = 106° und eine Wellenlänge von 157 nm aufweist, so ergibt sich bei einer numerischen Apertur NA = 0,8 des optischen Systems bei einer Druckspannung auf das Korrekturelement 25 von σ = -6,3 MPa ein maximaler Phasenunterschied von 6°. Dies entspricht einer Reduzierung des maximalen Phasenunterschiedes von 50° ohne angelegte Druckspannung auf ca. 12%.

### Bezugszeichenliste:

- 10: optische Achse
- 11: erstes optisches Element
- 12: zweites optisches Element
- 13: plane Fläche
- 14: gekrümmte Fläche
- 15: plane Fläche
- 16: gekrümmte Fläche
- 17: erstes optisches Element
- 18: zweites optisches Element
- 19: erstes optisches Element
- 20: zweites optisches Element
- 21: konvex gekrümmte Fläche
- 22: konkav gekrümmte Fläche
- 23: erste konvex gekrümmte Fläche
- 24: zweite konvex gekrümmte Fläche
- 25: Korrekturelement
- 26: erstes optisches Element
- 27: zweites optisches Element

## Patentansprüche

1. Optisches System mit kompensierter Spatial Dispersion, das eine optische Achse (10) aufweist, entlang derer mindestens ein erstes und ein zweites optisches Element (11, 17, 19, 26) angeordnet ist, wobei das erste Element in bezug auf die optische Achse (10) eine erste Orientierung aufweist, und das zweite optische Element (12, 18, 20, 27) eine, in bezug auf die optische Achse (10), entsprechende zweite Orientierung aufweist, **dadurch gekennzeichnet, daß** mindestens das erste optische Element (11, 17, 19, 26) und/oder das zweite optische Element (12, 18, 20, 27) mit einer Druckspannung (σ, σ1, σ2) in bezug auf die optische Achse (10) radial symmetrisch zum Kompensieren der Spatial Dispersion vorspannbar ist.

2. Optisches System nach Anspruch 1, **dadurch gekennzeichnet, daß** die Druckspannung (σ, σ1, σ2) homogen und isotrop ist.

3. Optisches System nach Anspruch 1 oder 2, **dadurch gekennzeichnet, daß** die Druckspannung (σ, σ1, σ2) 0,5 bis 50 MPa beträgt, vorzugsweise 0,6 bis 1,6 MPa.

4. Optisches System nach einem der vorhergehenden Ansprüche, **dadurch gekennzeichnet, daß** das erste optische Element (11, 17, 19, 26) und/oder das zweite optische Element (12, 18, 20, 27) in einen ebenen Spannungszustand in einer Ebene senkrecht zur optischen Achse (10) vorgespannt ist.

5. Optisches System nach einem der vorhergehenden Ansprüche, **gekennzeichnet durch** einen Vorrichtung zum Erzeugen der Druckspannung (σ, σ1, σ2).

6. Optisches System nach einem der vorhergehenden Ansprüche, **gekennzeichnet durch** Stellmittel zum Einstellen der Druckspannung (σ, σ1, σ2).

7. Optisches System nach einem der vorhergehenden Ansprüche, **dadurch gekennzeichnet, daß** das erste optische Element (19) mit einer ersten Druckspannung (σ1) und das zweite optische Element (20) mit einer von dieser verschiedenen zweiten Druckspannung (σ2) vorgespannt ist.

8. Optisches System nach einem der vorhergehenden Ansprüche, **dadurch gekennzeichnet, daß** das optische Element aus einem Material mit kubischer Kristallstruktur besteht, vorzugsweise CaF₂ oder BaF₂.

9. Optisches System nach einem der vorhergehenden Ansprüche, **dadurch gekennzeichnet, daß** schnelle Achsen der ersten Orientierung langsamen Achsen der zweiten Orientierung zugeordnet sind und umgekehrt.

10. Optisches System nach einem der vorhergehenden Ansprüche, **dadurch gekennzeichnet, daß** bei einer vierfachen Drehsymmetrie des Materials in der ersten Orientierung um die optische Achse der Winkel 45°, 135°, 225° oder 315° und/oder daß bei einer dreifachen Drehsymmetrie des Materials in der ersten Orientierung um die optische Achse der Winkel 60°, 180° oder 300° beträgt.

11. Optisches System nach einem der vorhergehenden Ansprüche, **dadurch gekennzeichnet, daß** die [100]-, [010]-, [001]-, [111] -, [-1-11] - oder die [1-11] -Achse in der ersten Orientierung und der zweiten Orientierung parallel zur optischen Achse angeordnet ist.

12. Optisches System nach einem der vorhergehenden Ansprüche, **dadurch gekennzeichnet, daß** das erste optische Element (11, 17, 19, 26) und das zweite optische Element (12, 18, 20, 27) einander zugeordnete Flächen (13, 15; 22, 23; 28, 29) aufweisen, die plan oder konvex/konkav bzw. konkav/konvex ausgebildet und einander zugewandt sind.

13. Optisches System nach einem der vorhergehenden Ansprüche, **dadurch gekennzeichnet, daß** das erste optische Element (11, 17, 19, 26) und das zweite optische Element (12, 18, 20, 27) die Endgruppe eines Objektivs bilden.

14. Optisches System nach einem der vorhergehenden Ansprüche, **dadurch gekennzeichnet, daß** das erste optische Element (26) und das zweite optische Element (27) ein planes Korrekturelement (25) bilden.

15. Optisches System nach Anspruch 15, **dadurch gekennzeichnet, daß** das erste optische Element (26) und das zweite optische Element (27) plane Schichten gleicher Dicke sind.

16. Verwendung eines optischen Systems nach einem der Ansprüche 1 - 15 in Linsen, Prismen, Lichtleitstäben, optischen Fenstern sowie optischen Komponenten für die DUV-Photolithographie, sowie zur Herstellung von Steppern, Excimer-lasern, Wafern, Computerchips, sowie integrierten Schaltungen und elektronischen Geräten, die solche Schaltungen und Chips enthalten.
